(19)

**Europäisches Patentamt**

**European Patent Office**

**Office européen des brevets**

(11) **EP 3 057 131 B1**

(12) **EUROPEAN PATENT SPECIFICATION**

(45) Date of publication and mention of the grant of the patent:
**17.06.2020 Bulletin 2020/25**

(51) Int Cl.:
*H01L 25/075* (2006.01)      *H01L 33/50* (2010.01)

(21) Application number: **16154900.1**

(22) Date of filing: **09.02.2016**

(54) **LIGHT-EMITTING DEVICE PACKAGE AND LIGHTING APPARATUS INCLUDING THE SAME**

GEHÄUSEVERPACKUNG EINER LICHTEMITTIERENDEN VORRICHTUNG UND BELEUCHTUNGSVORRICHTUNG DAMIT

BOÎTIER DE DISPOSITIF ÉLECTROLUMINESCENT ET APPAREIL D'ÉCLAIRAGE COMPRENANT CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.02.2015 KR 20150023223**

(43) Date of publication of application:
**17.08.2016 Bulletin 2016/33**

(73) Proprietor: **LG Innotek Co., Ltd.**
**Seoul, 04637 (KR)**

(72) Inventor: **MOON, Ji Wook**
**04637 Seoul (KR)**

(74) Representative: **Plasseraud IP**
**66, rue de la Chaussée d'Antin**
**75440 Paris Cedex 09 (FR)**

(56) References cited:
**EP-A1- 2 940 745**     **WO-A1-2014/068440**
**WO-A1-2014/104147**    **US-A1- 2008 048 193**
**US-A1- 2009 243 504**    **US-A1- 2015 008 463**

**Description**

## TECHNICAL FIELD

Embodiments relate to a light-emitting device package and a lighting apparatus including the same.

## BACKGROUND

Light-emitting devices, such as Light-emitting Diodes (LEDs) or laser diodes, which use group III-V or group II-VI compound semiconductors, are capable of emitting visible and Ultra Violet (UV) light of various colors, such as red, green, and blue, owing to development of device materials and thin film growth techniques. Moreover, these light emitting devices are capable of emitting white light with high luminous efficacy through use of phosphors or color combination, and have advantages of low power consumption, semi-permanent lifespan, fast response time, safety and environmental friendliness, compared to conventional light sources such as, for example, fluorescent lamps and incandescent lamps.

Methods of emitting white light are divided into single chip type methods, in which phosphors are coupled to an Ultra Violet (UV) light-emitting diode chip, and multi-chip type methods in which a plurality of chips is combined with one another to realize white light.

In the case of a representative multi-chip type method, three kinds of chips, namely Red, Green, and Blue (RGB) chips, are combined with one another. This method, however, problematically causes variation in color coordinates due to the uneven operating voltages of the respective chips or differences between the outputs of the respective chips caused by the surrounding environment.

In addition, in the case where a single chip is used to emit white light, there is used a method of attaining white light by exciting at least one kind of phosphors using light emitted from a blue LED.

Meanwhile, for example, in a display apparatus, a lighting apparatus using LED chips may be used as a light source. Such a display application requires a lighting apparatus having high luminance as well as high color purity in order to achieve a high color reproduction capacity.

Documents WO 2014/068440 A1, US 2015/0008463 A1, US 2009/0243504 A1 and US 2008/0048193 A1 disclose LEDs with phosphors embedded in a resin molding member to adjust the light emission spectrum of a package including such LEDs.

WO2014/104147 discloses a wavelength conversion member.

## SUMMARY

Embodiments provide a phosphor composition, which achieves high color purity through the inclusion of a blue light-emitting device, a green light-emitting device, and red phosphors, a light-emitting device package, and a lighting apparatus.

In one embodiment, a light-emitting device package is provided in accordance with claim 1.

Embodiments are further defined in claims 2-13.

In addition, in a further embodiment, a lighting apparatus is provided in accordance with claims 14-15.

## BRIEF DESCRIPTION OF THE DRAWINGS

Arrangements and embodiments may be described in detail with reference to the following drawings in which like reference numerals refer to like elements and wherein:

FIG. 1 is a view illustrating a light-emitting device package in accordance with an embodiment according to the invention;

FIG. 2 is a view illustrating a light-emitting device in accordance with an embodiment according to the invention;

FIG. 3 is a view illustrating another embodiment of a light-emitting device package not according to the invention;

FIGs. 4A and 4B are views illustrating the emission spectra of light-emitting device packages;

FIG. 5 is a view illustrating one embodiment of a lighting apparatus;

FIG. 6 is a view illustrating the results of simulating color coordinates in relation to Comparative Examples; and

FIGs. 7 and 8 are views illustrating the results of simulating color coordinates in relation to Examples.

## DESCRIPTION OF SPECIFIC EMBODIMENTS

Hereinafter, exemplary embodiments to concretely realize the above-described object will be described with reference to the accompanying drawings.

In the following description of the embodiments, it will be understood that, when each element is referred to as being formed "on" or "under" the other element, it can be directly "on" or "under" the other element or be indirectly formed with one or more intervening elements therebetween. In addition, it will also be understood that "on" or "under" the element may mean an upward direction and a downward direction of the element.

In addition, the relative terms "first", "second", "top/upper/above", "bottom/lower/under" and the like in the description and in the claims may be used to distinguish between any one substance or element and other substances or elements and not necessarily for describing any physical or logical relationship between the substances or elements or a particular order.

In the drawings, the thickness or size of each layer may be exaggerated, omitted or schematically illustrated for clarity and convenience. In addition, the size of each constituent element does not wholly reflect an actual size thereof.

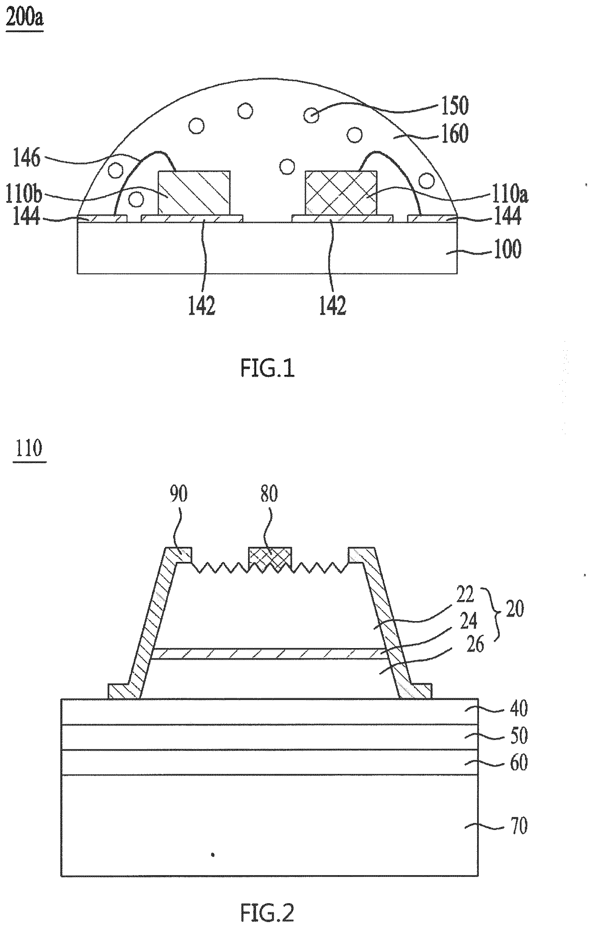

FIG. 1 is a view illustrating a light-emitting device package in accordance with an embodiment according to the invention.

The light-emitting device package in accordance with the embodiment, designated by reference numeral 200a, may include a first lead frame 142 and a second lead frame 144, a first light-emitting device 110a and a second light-emitting device 110b disposed on the first lead frame 142 and the second lead frame 144, and a molding part 160 disposed to surround the first and second light-emitting devices 110a and 110b.

Referring to FIG. 1, the first lead frame 142 and the second lead frame 144 may be electrically connected to the first light-emitting device 110a and the second light-emitting device 110b.

The first lead frame 142 and the second lead frame 144 may be fixedly disposed on a substrate 100. At this time, the substrate 100 may be formed of a ceramic material having excellent thermal conductivity, and for example, may be a sapphire ($Al_2O_3$) substrate.

The first lead frame 142 and the second lead frame 144 may be formed of a conductive material such as, for example, copper, and may be disposed after being plated with, for example, gold (Au).

The first lead frame 142 and the second lead frame 144 may be electrically separated from each other, and may supply current to the light-emitting devices 110a and 110b. In addition, the first lead frame 142 and the second lead frame 144 may reflect light emitted from the light-emitting devices 110a and 110b so as to increase luminous efficacy, and may outwardly discharge heat generated in the light-emitting devices 110a and 110b.

Although the light-emitting devices 110a and 110b may be disposed on the first lead frame 142 and may be connected to the second lead frame 144 using wires 146 in the embodiment illustrated in FIG. 1, the light-emitting devices 110a and 110b may be connected to the lead frame via flip-chip bonding or die-bonding, in addition to wire-bonding.

The light-emitting devices 110a and 110b may be light-emitting diodes.

FIG. 2 is a view illustrating one embodiment of the light-emitting devices 110a and 110b. Each of the light-emitting devices 110a and 110b may include a support substrate 70, a light-emitting structure 20, an ohmic layer 40, and a first electrode 80.

The light-emitting structure 20 may include a first conductive semiconductor layer 22, an active layer 24, and a second conductive semiconductor layer 26.

The first conductive semiconductor layer 22 may be formed of, for example, group III-V or group II-VI compound semiconductors, and may be doped with a first conductive dopant. The first conductive semiconductor layer 22 may be formed of any one or more selected from among semiconductor materials having a composition of $Al_xIn_yGa_{(1-x-y)}N$ ($0 \leq x \leq 1$, $0 \leq y \leq 1$, $0 \leq x+y \leq 1$), AlGaN, GaN, InAlGaN, AlGaAs, GaP, GaAs, GaAsP and AlGaInP.

When the first conductive semiconductor layer 22 is an n-type semiconductor layer, the first conductive dopant may include an n-type dopant such as, for example, Si, Ge, Sn, Se, or Te. The first conductive semiconductor layer 22 may be formed into a single layer or multiple layers, without being limited thereto.

The active layer 24 may be disposed between the first conductive semiconductor layer 22 and the second conductive semiconductor layer 26, and may include any one selected from among a single-well structure, a multi-well structure, a single-quantum well structure, a multi-quantum well structure, a quantum dot structure, and a quantum wire structure.

The active layer 24 may be formed of group III-V compound semiconductors, and may include a well layer and a barrier layer having a pair structure of any one or more selected from among AlGaN/AlGaN, InGaN/GaN, InGaN/InGaN, AlGaN/GaN, InAlGaN/GaN, GaAs(InGaAs)/AlGaAs and GaP(InGaP)/AlGaP, without being limited thereto. The well layer may be formed of a material having lower band gap energy than the band gap energy of the barrier layer.

The second conductive semiconductor layer 26 may be formed of compound semiconductors. That is, the second conductive semiconductor layer 26 may be formed of, for example, group III-V or group II-VI compound semiconductors, and may be doped with a second conductive dopant. For example, the second conductive semiconductor layer 26 may be formed of any one or more selected from among semiconductor materials having a composition of $In_xAl_yGa_{1-x-y}N$ ($0 \leq x \leq 1$, $0 \leq y \leq 1$, $0 \leq x+y \leq 1$), AlGaN, GaN, AlInN, AlGaAs, GaP, GaAs, GaAsP, and AlGaInP, and for example, may be formed of a material having a composition of $Al_xGa_{(1-x)}N$.

When the second conductive semiconductor layer 26 is a p-type semiconductor layer, the second conductive dopant may be a p-type dopant such as, for example, Mg, Zn, Ca, Sr or Ba. The second conductive semiconductor layer 26 may be formed into a single layer or multiple layers, without being limited thereto.

The first conductive semiconductor layer 22 may have a patterned surface to improve light-extraction efficiency. In addition, the first electrode 80 may be disposed on the surface of the first conductive semiconductor layer 22. Although not illustrated, the surface of the first conductive semiconductor layer 22, on which the first electrode 80 is disposed, may not be patterned. The first electrode 80 may be formed of at least one selected from among aluminum (Al), titanium (Ti), chrome (Cr), nickel (Ni), copper (Cu) and gold (Au), and may be formed into a single layer or multiple layers.

A passivation layer 90 may be formed around the light-emitting structure 20. The passivation layer 90 may be formed of an insulating material, such as non-conductive oxide or nitride. For example, the passivation layer 90 may be formed of a silicon oxide ($SiO_2$) layer, an oxide nitride layer, and an oxide aluminum layer.

A second electrode must be disposed below the light emitting structure 20. The ohmic layer 40 and a reflective layer 50 may serve as the second electrode. A GaN layer may be disposed below the second conductive semiconductor layer 26 to ensure the smooth introduction of current and holes into the second conductive semiconductor layer 26.

The ohmic layer 40 may have a thickness of about 200 angstroms (Å). The ohmic layer 40 may be formed of at least one selected from among Indium Tin Oxide (ITO), Indium Zinc Oxide (IZO), Indium Zinc Tin Oxide (IZTO), Indium Aluminum Zinc Oxide (IAZO), Indium Gallium Zinc Oxide (IGZO), Indium Gallium Tin Oxide (IGTO), Aluminum Zinc Oxide (AZO), Antimony Tin Oxide (ATO), Gallium Zinc Oxide (GZO), IZO Nitride (IZON), Al-Ga ZnO (AGZO), In-Ga ZnO (IGZO), ZnO, IrOx, RuOx, NiO, RuOx/ITO, Ni/IrOx/Au, Ni/IrOx/Au/ITO, Ag, Ni, Cr, Ti, Al, Rh, Pd, Ir, Sn, In, Ru, Mg, Zn, Pt, Au, and Hf, but is not limited to these materials.

The reflective layer 50 may be a metal layer formed of molybdenum (Mo), aluminum (Al), silver (Ag), nickel (Ni), platinum (Pt), rhodium (Rh), or alloys including Al, Ag, Pt or Rh. The reflective layer 50 may effectively reflect light emitted from the active layer 24, so as to significantly enhance light-extraction efficiency of a semiconductor device.

The support substrate 70 may be formed of a conductive material such as, for example, a metal or a semiconductor material. More particularly, the support substrate 70 may be formed of a metal having high electric conductivity and thermal conductivity. Since the support substrate 70 needs to sufficiently dissipate heat generated during operation of a semiconductor device, the support substrate 70 may be formed of a high thermal conductivity material (e.g. a metal).

For example, the support substrate 70 may be formed of a material selected from the group of molybdenum (Mo), silicon (Si), tungsten (W), copper (Cu) and aluminum (Al), or alloys thereof. In addition, the support substrate 70 may selectively comprise gold (Au), copper (Cu) alloy, nickel (Ni), copper-tungsten (Cu-W), carrier wafer (for example, any one of GaN, Si, Ge, GaAs, ZnO, SiGe, SiC, SiGe and $Ga_2O_3$).

The support substrate 70 may have a thickness within a range from 50 $\mu$m to 200 $\mu$m, in order to achieve a sufficient mechanical strength to be efficiently separated as a chip during a scribing process and a breaking process without causing bending of a nitride semiconductor device.

A bonding layer 60 serves to bond the reflective layer 50 and the support substrate 70 to each other. The bonding layer 60 may be formed of a material selected from the group of gold (Au), tin (Sn), indium (In), aluminum (Al), silicon (Si), silver (Ag), nickel (Ni), and copper (Cu), or alloys thereof.

The embodiment of the light-emitting device 110 illustrated in FIG. 2 relates to a vertical type light-emitting device, whereas the embodiment of the light-emitting device package 200a illustrated in FIG. 1 may employ a horizontal type light-emitting device or a flip-chip type light-emitting device, instead of the vertical type light-emitting device illustrated in FIG. 2.

Meanwhile, the first light-emitting device 110a may emit light of a first wavelength range.

For example, the first light-emitting device 110a may emit blue light, and the center wavelength of light emitted from the first light-emitting device 110a may be within a range from 440 nm to 460 nm.

The second light-emitting device 110b may emit light of a second wavelength range, which is different from that of the first light-emitting device 110a.

For example, the second light-emitting device 110b may emit green light, and the center wavelength of light emitted from the second light-emitting device 110b may be within a range from 520 nm to 535 nm.

Referring again to FIG. 1, in the light-emitting device package 200a in accordance with the embodiment, the molding part 160 is disposed so as to surround the first light-emitting device 100a and the second light-emitting device 100b.

The molding part 160 has a dome shape, and according to embodiments not forming part of the claimed invention may have any of various other shapes in order to adjust the emission angle of light emitted from the light-emitting device package 200a. The molding part 160 may serve as a lens that surrounds and protects the light-emitting devices 110a and 110b and changes the path of light emitted from the light-emitting devices 110a and 110b.

The molding part 160 may include a resin base and red phosphors 150 distributed in the resin base.

The red phosphors 150 are phosphors that emit light in a red wavelength range when excited.

The resin base may be formed of any one of silicon-based resin, epoxy-based resin, and acryl-based resin, or mixtures thereof.

In addition, the molding part 160 includes fluoro-based red phosphors 150.

The fluoro-based red phosphors 150 may be excited by at least one of the first light-emitting device 110a and the second light-emitting device 110b.

The fluoro-based red phosphors, included in the molding part 160, may be indicated by the chemical formula $K_2MF_6:Mn^{4+}$. Here, "M" may be at least one of silicon (Si), germanium (Ge), and titanium (Ti).

The emission center wavelength of the fluoro-based red phosphors 150 may be within a range from 620 nm to 640 nm. Here, the "emission center wavelength of the red phosphors 150" refers to the center wavelength of light emitted when the red phosphors 150 are excited by at least one of the first light-emitting device 110a and the second light-emitting device 110b.

In addition, the fluoro-based red phosphors may have a smaller Full Width at Half Maximum (FWHM) than conventional nitride-based red phosphors.

For example, the FWHM of the fluoro-based red phosphors is within a range from 5 nm to 10 nm.

The fluoro-based red phosphors are included in the molding part in an amount within a range from 5 wt% to 25 wt%.

That is, in the case where the molding part includes silicon resin and fluoro-based red phosphors, assuming that the weight of the silicon resin is Ws and the weight of the fluoro-based red phosphors is Wr, the ratio of the fluoro-based red phosphors to the molding part $\left(\dfrac{Wr}{Ws+Wr}\right)\times 100$ may be as follows:

$$5wt\% < \left(\frac{Wr}{Ws+Wr}\right)\times 100 < 25wt\%$$

For example, when the fluoro-based red phosphors are included in an amount of 5 wt% or less, the amount of red phosphors relative to the content of the molding part is insufficient, which may deteriorate the color purity of the red light, among the light emitted from the light-emitting device package. On the other hand, when the fluoro-based red phosphors are included in the molding part in an amount of 25 wt% or more, the amount of light absorbed by the red phosphors relative to the amount of light emitted from the light-emitting device package is increased, which may reduce the overall luminance of the light-emitting device package.

In addition, when the fluoro-based red phosphors are included in the molding part in an amount of 25 wt% or more, the optical characteristics of the light-emitting device package may be deteriorated when the light-emitting device package is used for a long time because the fluoro-based red phosphor is vulnerable to temperature, humidity, and light.

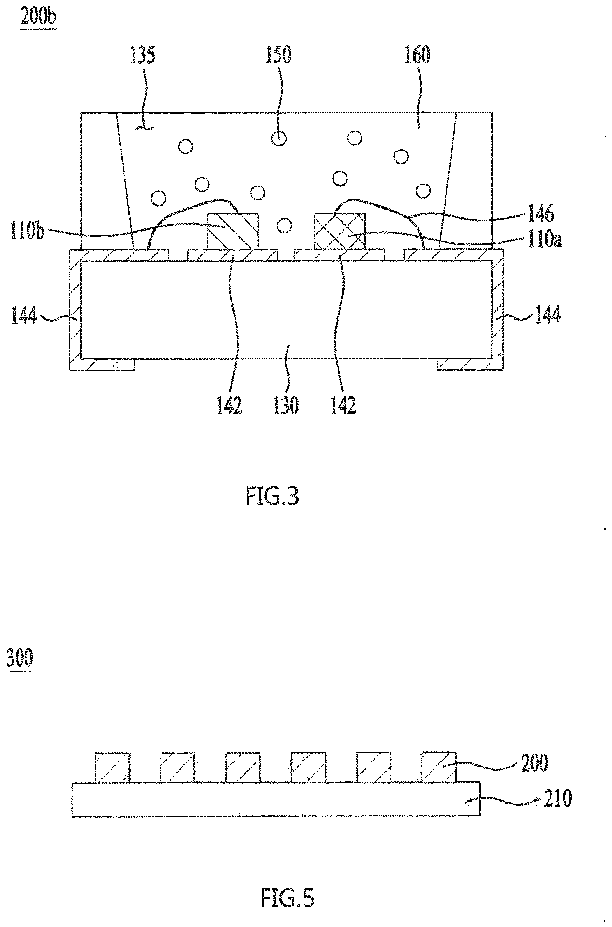

FIG. 3 is a view illustrating another embodiment not according to the invention of a light-emitting device package 200b.

In the following description related to the light-emitting device package of FIG. 3, repeated descriptions related to the embodiment of the light-emitting device package of FIG. 1 will be omitted, and the light-emitting device package of FIG. 3 will be described only with an eye to the differences therebetween.

The light-emitting device package 200b in accordance with one embodiment illustrated in FIG. 3 may include a package body 130 having a cavity 135 and first and second light-emitting devices 110a and 110b disposed on the bottom surface of the cavity 135. The first lead frame 142 and the second lead frame 144 may be secured to the package body 130 so as to be electrically connected to the light-emitting devices 110a and 110b.

In addition, the cavity 135 may be filled with the molding part 160 so that the molding part 160 surrounds the light-emitting devices 110a and 110b.

The package body 130 may be formed of a silicon material, a synthetic resin material, or a metal material, and may be formed of a ceramic material having excellent thermal conductivity.

The top of the package body 130 may be open, and the cavity 135 may be defined by the side surface and bottom surface of the package body 130.

The cavity 135 may have, for example, a cup shape or a concave container shape, and the side surface of the cavity 135 may be perpendicular to or tilted relative to the bottom surface, and may have various sizes and shapes.

The cavity 135 may have, for example, a circular shape, a polygonal shape, or an oval shape when viewed from the top and may have curved corners, without being limited thereto.

The light-emitting devices 110a and 110b may be located inside the cavity 135, and may be disposed on the package body 130, or may be disposed on the first lead frame 142 or the second lead frame 144.

Although the light-emitting devices 110a and 110b provided in the light-emitting device package of FIG. 3 may be vertical type light-emitting devices illustrated in FIG. 2, the embodiment is not limited thereto, and may include, for example, horizontal type light-emitting devices.

In the embodiment of FIG. 3, the cavity 135 may be filled with the molding part 160 and the molding part 160 may be disposed on the package body so as to surround the two light-emitting devices 110a and 110b.

At this time, although the upper surface of the molding part 160 may be formed on the same line as the top of the side surface of the cavity 135, the embodiment is not limited thereto, and the upper surface of the molding part 160 may be formed higher or lower than the top of the side surface of the cavity 135.

In the present embodiment, the molding part 160 may include the resin base and the red phosphors 150 distributed in the resin base. The composition and weight percent of the respective components may be the same as those in the above-described embodiment.

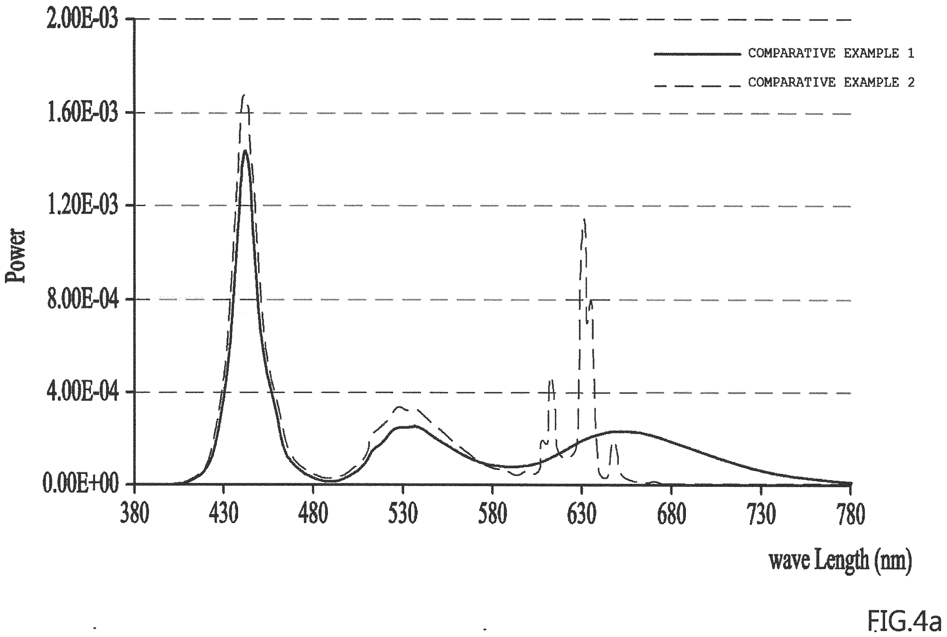

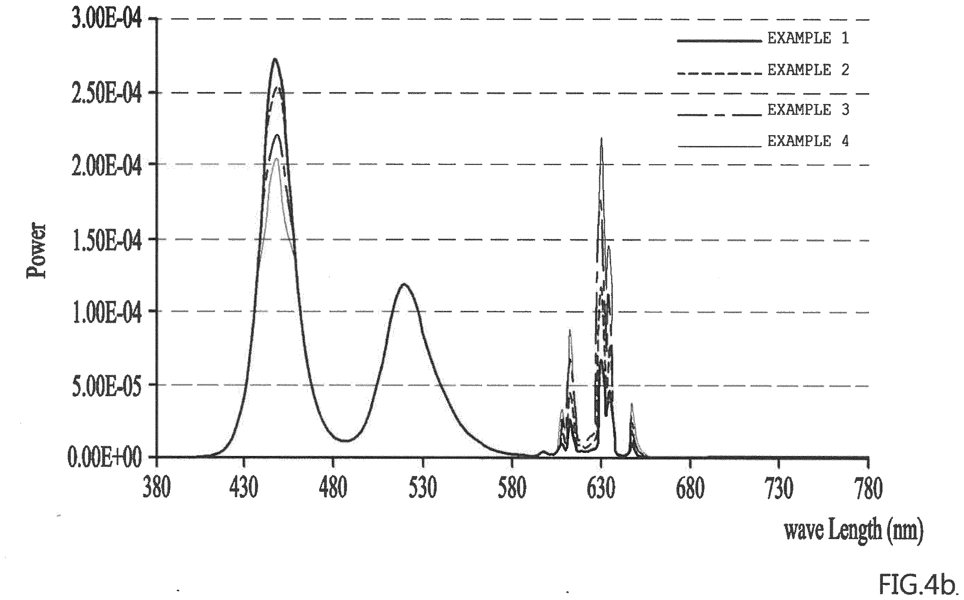

FIGs. 4A and 4B are views illustrating the emission spectra of light-emitting device packages.

FIG. 4A illustrates the emission spectra of conventional light-emitting device packages. Comparative Example 1 illustrates the case of a light-emitting device package that includes a light-emitting device that emits blue light as well as red phosphors and green phosphors on the blue light-emitting device. The green phosphors and red phosphors are phosphors that emit light in a green wavelength range and light in a red wavelength range respectively when excited. In addition, Comparative Example 2 illustrates the case of a light-emitting device package that includes a light-emitting device that emits blue light as well as green phosphors and fluoro-based red phosphors on the blue light-emitting device.

Meanwhile, FIG. 4B is a view illustrating the emission spectra of light-emitting device packages in accordance with Examples. Here, Examples 1 to 4 may have the configuration of the light-emitting device package in accordance with the embodiment illustrated in FIG. 3.

Table 1 illustrates the configuration of molding parts in accordance with Comparative Example 1, Comparative Example 2, and Examples 1 to 4.

At this time, the resin base constituting the molding parts in accordance with Comparative Example 1, Comparative Example 2, and Examples 1 to 4, described in Table 1, may be silicon resin.

Table 1

| Sort | Total Weight Percent of Phosphor (wt%) | Phosphor 1(%) | Phosphor 2(%) | Phosphor 3(%) |
|---|---|---|---|---|
| Comparative Example 1 | 10 | 88 | 12 | |
| Comparative Example 2 | 27 | 26.5 | | 73.5 |
| Example 1 | 5 | | | 100 |
| Example 2 | 10 | | | 100 |
| Example 3 | 15 | | | 100 |
| Example 4 | 20 | | | 100 |

In Table 1, the total weight percent (wt%) of phosphors indicates the ratio of the weight of the phosphor composition to the total weight of the molding part, and the total weight of the molding part may include the weights of the resin base and the phosphor composition. At this time, in the case where different kinds of phosphors are included in the molding part, the total weight of the phosphors may include the weights of all of the different kinds of phosphors.

That is, Comparative Example 1 illustrates the case where Phosphor 1 and Phosphor 2 occupy 10 wt% in the molding part, Comparative Example 2 illustrates the case where Phosphor 1 and Phosphor 3 occupy 27 wt% in the molding part, and Examples illustrate the case where only Phosphor 3 is included in the molding part in an amount within a range from 5 wt% to 20 wt%.

At this time, silicon resin forming the resin base may account for 90 wt% in Comparative Example 1, 73% in Comparative Example 2, and within a range from 80 wt% to 95% in Examples 1 to 4.

In addition, Phosphor 1 may correspond to nitride-based green phosphors, Phosphor 2 may correspond to nitride-based red phosphors, and Phosphor 3 may correspond to fluoro-based red phosphors.

For example, Phosphor 1 may be $Ba_3Si_6O_{12}N_2:Eu^{2+}$, Phosphor 2 may be $Ca_2Si_5N_8:Eu^{2+}$, and Phosphor 3 may be $K_2SiF_6:Mn^{4+}$.

FIG. 4A illustrates the emission spectra of the light-emitting device packages in accordance with Comparative Example 1 and Comparative Example 2. In the case of Comparative Example 2, it can be seen that the emission spectrum has a sharp emission peak and considerably increased lighting power in a red light-emitting wavelength range, compared to Comparative Example 1.

That is, in the case of Comparative Example 2, it can be appreciated that the light-emitting device package achieves enhanced luminance and color purity of red light thanks to the use of the fluoro-based red phosphors, unlike Comparative Example 1.

FIG. 4B illustrates the emission spectra of the light-emitting device packages in accordance with Examples based on the content ratio of Phosphor 3. Meanwhile, in FIG. 4B, Examples 1 to 4 correspond to emission spectra in the case where the content of Phosphor 3 included in the molding part is varied.

Referring to Table 1, the content ratio of Phosphor 3 relative to the molding part is 5 wt% in Example 1, 10 wt% in Example 2, 15 wt% in Example 3, and 20 wt% in Example 4.

Referring to FIG. 4B, compared to the emission spectra of Comparative Example 1 and Comparative Example 2 in FIG. 4A, it can be appreciated that the emission spectra of Examples have sharp emission peaks in a red light-emitting wavelength range from 580 nm to 680 nm, unlike Comparative Example 1, and also have more sharp emission peaks in a green light-emitting wavelength range from 480 nm to 580 nm, compared to Comparative Example 1 and Comparative Example 2.

That is, in the case of the light-emitting device package in accordance with the embodiment, by replacing green phosphors with a green light-emitting device and by using fluoro-based red phosphors, the emission spectrum may attain sharp emission peaks having a narrow FWHM in green and red light-emitting wavelength ranges, compared to the light-emitting device packages of Comparative Examples, thereby achieving higher color purity than the case where only a light-emitting device that emits blue light is used.

FIG. 5 is a view illustrating one embodiment of a lighting apparatus.

The lighting apparatus 300 in accordance with the embodiment may include at least one light-emitting device package 200 of the above-described embodiment.

FIG. 5 is a sectional view of the lighting apparatus 300 including a support member 210 and a plurality of light-emitting device packages 200.

Meanwhile, although not illustrated in FIG. 5, the support member 210 may be a circuit board patterned with an electrode thereon, and for example, may be a Printed Circuit Board (PCB) or a Flexible Printed Circuit Board (FPCB).

The light-emitting device packages 200 may be disposed on the electrode pattern formed on the support member 210.

In addition, the lighting apparatus in accordance with one embodiment may be used as a light source of a display apparatus.

For example, the display apparatus may include an image panel to form an image, and the lighting apparatus to supply light to the image panel. At this time, the lighting apparatus included in the display apparatus in accordance with one embodiment may be a backlight unit or a front light unit, and may supply light to the image panel, which forms an image.

In some embodiments, an array of a plurality of lighting apparatuses may be used, and a single lighting apparatus may be used as a light source.

In the case of a backlight unit in which the lighting apparatus of the embodiment is used as the light source of the display apparatus, the lighting apparatus may further include a bottom cover, and a reflective layer disposed on the bottom cover to increase luminous efficacy.

In addition, in the case where the lighting apparatus is included in the display apparatus, the lighting apparatus may further include an optical member on the light-emitting device package.

The optical member may include, for example, a light guide plate and a prism sheet, and may function to transmit light, emitted from the light-emitting device package of the lighting apparatus, to the image panel and to increase the luminous efficacy of the lighting apparatus.

In the lighting apparatus of the embodiment, the light-emitting device package may emit white light in which blue light, green light and red light are mixed.

Of the mixed light from the lighting apparatus, the blue light may have color coordinates, located within a rectangle defined by X and Y coordinates, of (0.130, 0.050), (0.160, 0.050), (0.130, 0.080) and (0.160, 0.080) on the basis of the CIE1931 color coordinate system.

In addition, of the mixed light from the lighting apparatus, the green light may have color coordinates, located within a rectangle defined by X and Y coordinates, of (0.140, 0.650), (0.160, 0.650), (0.140, 0.680) and (0.160, 0.680) on the basis of the CIE1931 color coordinate system.

In addition, of the mixed light from the lighting apparatus, the red light may have color coordinates, located within a rectangle defined by X and Y coordinates, of (0.600, 0.260), (0.690, 0.260), (0.600, 0.310) and (0.690, 0.310) on the basis of the CIE1931 color coordinate system.

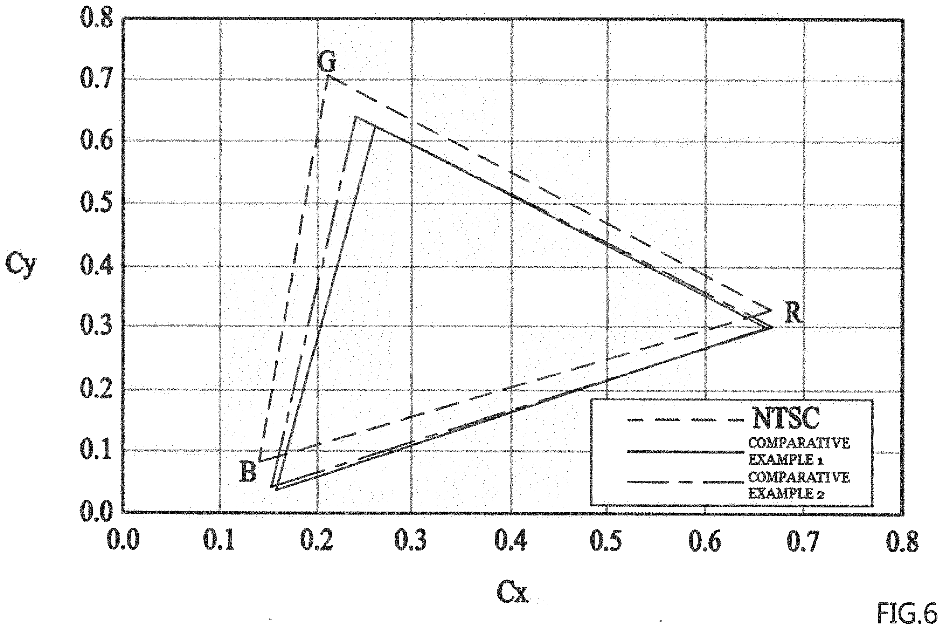

FIGs. 6 to 8 illustrate the results of simulating color coordinates on a Liquid Crystal display Module (LCM).

In addition, Table 2 and Table 3 illustrate the simulated values of color coordinates at Red, Green and Blue points on the LCM in accordance with Comparative Examples and Examples.

In FIGs. 6 to 8, $C_x$ is the X-axis value of the color coordinates, and Cy is the Y-axis value of the color coordinates.

FIG. 6 and Table 2 show the results of simulating the color coordinates and color production capacity of the LCM in the case where the lighting apparatus includes the light-emitting device packages of Comparative Examples described above. At this time, the configurations of the light-emitting device packages of Comparative Example 1 and Comparative Example 2 may be understood with reference to Table 1 described above.

The color coordinates of standard Red, Green and Blue of the National Television System Committee (NTSC), indicated by the CIE1931 color coordinate system, may be (0.67, 0.33), (0.21, 0.71), and (0.14, 0.08) respectively.

In addition, the NTSC area ratio (%) illustrated in Table 2 and Table 3 may refer to the ratio of the area of a triangle, defined by new three R, G and B color coordinates in accordance with Comparative Examples or Examples, to the area of a triangle defined by NTSC standard R, G and B color coordinates.

For example, the NTSC area ratio may be a value of color reproduction capacity.

FIG. 6 is a view illustrating the NTSC triangle and triangles defined by three R, G and B points in Comparative Example 1 and Comparative Example 2 indicated in the color coordinate system.

Referring to FIG. 6, it can be appreciated that the areas of the triangles of Comparative Example 1 and Comparative Example 2 do not coincide with that of the NTSC triangle and the triangle of Comparative Example 2 is greater than the triangle of Comparative Example 1.

In addition, referring to Table 2, it can be seen that the NTSC area ratio of Comparative Example 2 is increased by about 4% compared to that of Comparative Example 1.

That is, in FIG. 6 and Table 2, it can be appreciated that the reason why the NTSC area ratio of Comparative Example 2 is higher than that of Comparative Example 1 is that the light-emitting device package of Comparative Example 2 includes the fluoro-based red phosphors, thereby achieving an increased color purity, and consequently an increased NTSC area ratio which is characterized by a color reproduction capacity. At this time, the fluoro-based red phosphors may be $K_2MF_6$:$Mn^{4+}$ (here, M is at least one of Si, Ge and Ti) .

Table 2

| Sort | Color Coordinates | Red | Green | Blue | NTSC area ratio (%) |
|---|---|---|---|---|---|
| Comparative Example 1 | $C_X$ | 0.661 | 0.258 | 0.155 | 86.3 |
| | $C_Y$ | 0.307 | 0.633 | 0.040 | |
| Comparative Example 2 | $C_X$ | 0.668 | 0.240 | 0.154 | 90.1 |
| | $C_Y$ | 0.304 | 0.645 | 0.042 | |

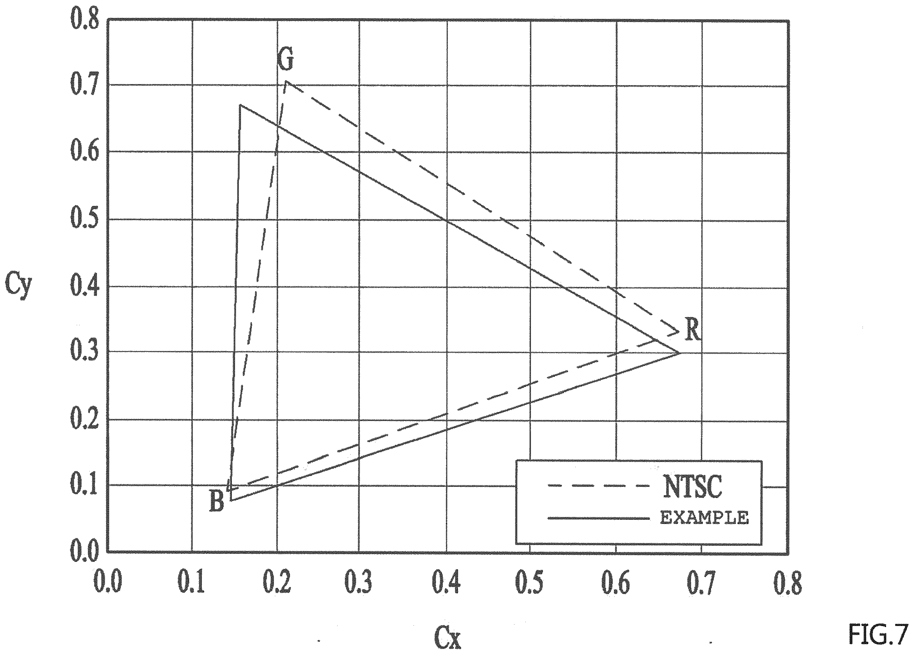

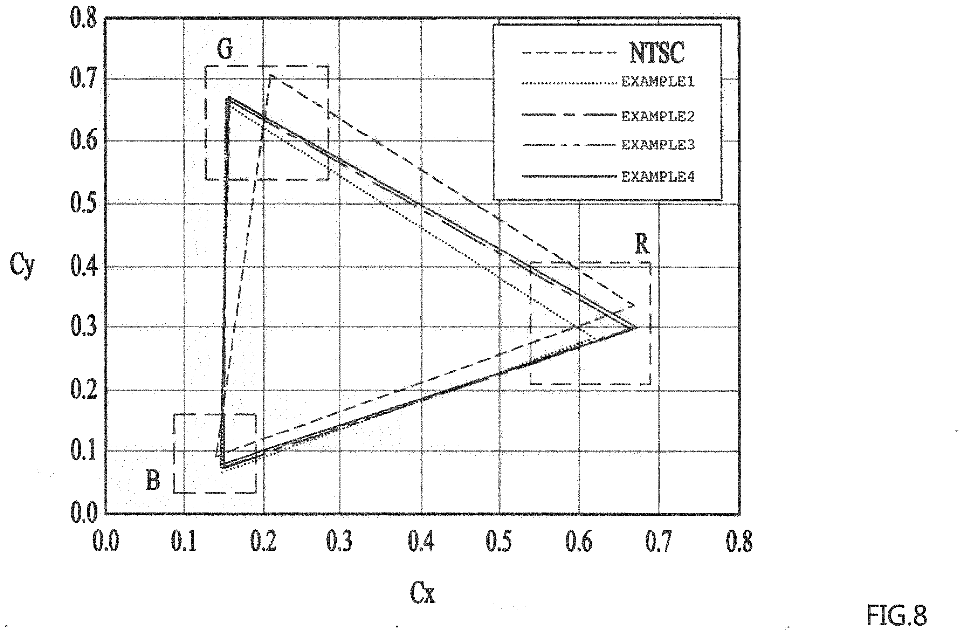

FIGs. 7 and 8 and Table 3 are the simulation results of the LCM including the lighting apparatus in accordance with Examples.

FIG. 7 is a graph comparing the NTSC standard R, G and B color coordinates with the color coordinates of Example, which includes the lighting apparatus of the embodiment.

Referring to FIG. 7, it can be appreciated that the Cx value, which is the X-axis value of the color coordinates, of green (G) in Example is small, compared to the color coordinates of Comparative Example 1 and Comparative Example 2 illustrated in FIG. 6.

That is, in the case of Example, owing to the inclusion of the green light-emitting device rather than green phosphors, the X-axis value of the color coordinates of green light is smaller than the X-axis value of the NTSC green color coordinates, unlike the color coordinates of Comparative Examples. Thus, the area of the triangle defined by three R, G and B points in Example is greater than the area of the triangles in Comparative Examples.

Referring to FIG. 7, it can be appreciated that the area of the triangle in Example does not coincide with that of the NTSC triangle, but the area of the triangle is increased compared to those in Comparative Example 1 and Comparative Example 2.

FIG. 8 is a graph comparing the color coordinates of Examples 1 to 4, and Table 3 illustrates the R, G and B color coordinates and the NTC area ratios of Examples 1 to 4.

Examples 1 to 4 correspond to the cases where the fluoro-based red phosphors included in the lighting apparatus of the above-described embodiment have different content ratios.

That is, the content ratio of the fluoro-based red phosphors may be 5 wt% in Example 1, 10 wt% in Example 2, 15 wt% in Example 3, and 20 wt% in Example 4. At this time, the fluoro-based red phosphors may be $K_2MF_6$:$Mn^{4+}$ (here, M is at least one of Si, Ge and Ti).

It can be appreciated with reference to the simulation results of FIG. 8 and Table 3 that the NTSC area ratio (%) increases as the content of the fluoro-based red phosphors increases.

Meanwhile, in the case of the lighting apparatus in accordance with the embodiment, the area of the triangle defined by blue light, green light and red light may be 90% or more of the area of the NTSC triangle.

In addition, it can be appreciated with reference to the simulation results of FIG. 8 and Table 3 that the X-axis value of the color coordinates of red light increases as the content ratio of the fluoro-based red phosphors increases in Examples.

That is, the Cx value, i.e. the X-axis value of the color coordinates of red light increases as the content ratio of the fluoro-based red phosphors increases from 5 wt% to 20 wt%, thereby being visibly closer to the Cx value of the NTSC Red color coordinates.

Accordingly, the area of a triangle in the CIE1931 color coordinate system of the LCM, which includes the lighting apparatus of the embodiment, increases as the content of the fluoro-based red phosphors increases, which may result in an increased color reproduction capacity.

It also can be seen from FIG. 8 that the area of the triangle defined by three R, G and B points increases from Example 1 to Example 4. That is, the color purity of the red region increases as the content of the fluoro-based red phosphors increases, which may result in an increase in the overall color reproduction capacity of the LCM.

Table 3

| Sort | Color Coordinate | Red | Green | Blue | NTSC Area Ratio (%) |
|---|---|---|---|---|---|
| Example 1 | $C_x$ | 0.617 | 0.153 | 0.147 | 89.7 |
| | $C_y$ | 0.278 | 0.663 | 0.057 | |
| Example 2 | $C_x$ | 0.664 | 0.155 | 0.146 | 91.6 |
| | $C_y$ | 0.295 | 0.671 | 0.064 | |
| Example 3 | $C_x$ | 0.671 | 0.155 | 0.146 | 93.3 |
| | $C_y$ | 0.297 | 0.674 | 0.067 | |
| Example 4 | $C_x$ | 0.671 | 0.155 | 0.146 | 95.3 |
| | $C_y$ | 0.297 | 0.674 | 0.067 | |

Meanwhile, the lighting apparatus may be included in, for example, a lamp or a headlamp, in addition to the display apparatus described above.

The lighting apparatus 300 illustrated in FIG. 5 may be a light source module.

The lamp may include the lighting apparatus of the embodiment, which is a light source module, and may further include a radiator, which dissipates heat from the light source module, and a power supply unit, which processes or converts electrical signals received from the outside and transmits the same to the light source module.

The headlamp may include the lighting apparatus 300 illustrated in FIG. 5, which is an emission module, and may further include a reflector, which reflects light emitted from the emission module in a given direction, for example, in a forward direction, a lens, which forwardly refracts the light reflected by the reflector, and a shade, which blocks or reflects part of the light that is reflected by the reflector and directed toward the lens, so as to achieve the light distribution pattern intended by the designer. Here, the reflector, lens, and shade may be referred to as optical members.

As is apparent from the above description, for example, in the case of a display apparatus, a lamp, or a headlamp including a lighting apparatus in accordance with the above-described embodiment, a light-emitting device package includes two light-emitting devices adapted to emit light of different wavelength ranges, for example, blue and green light-emitting devices, and fluoro-based red phosphors having a small FWHM, whereby high color purity of light emitted when a phosphor composition is excited, thereby achieving an increased color reproduction capacity.

Although embodiments have been described with reference to a number of illustrative embodiments thereof, it should be understood that numerous other modifications and embodiments can be devised by those skilled in the art that will fall within the scope of this invention as defined by the claims. More particularly, various variations and modifications are possible in the component parts and/or arrangements of the subject combination arrangement within the scope of the invention as defined by the appended claims. In addition to variations and modifications in the component parts and/or arrangements, alternative uses will also be apparent to those skilled in the art.

**Claims**

1. A light-emitting device package comprising:

a first light-emitting device (110a) disposed on a lead frame (142, 144) and configured to emit light in a first wavelength range and a second light-emitting device (110b) configured to emit light in a second wavelength range, which is different from the first wavelength range; and

a molding part (160) disposed to surround the first light-emitting device (110a) and the second light-emitting device (110b),

wherein the molding part (160) includes red phosphors (150), which are excited by the light emitted from at least one of the first light-emitting device (110a) and the second light-emitting device (110b), and

wherein the molding part (160) has a dome shape, and varies an emission angle of light from the first light-emitting device (110a) and the second light-emitting device (110b),

**characterized in that** the red phosphors are fluoro-based red phosphors (150),

wherein the fluoro-based red phosphors (150) have a full width at half maximum within a range from 5 nm to 10 nm, and wherein the fluoro-based red phosphors (150) are included in the molding part in an amount within a range from 5 wt% to 25 wt%.

2. The package according to claim 1, wherein the fluoro-based red phosphors (150) are indicated by the chemical formula $K_2MF_6:Mn^{4+}$ (here, M is at least one of Si, Ge, and Ti).

3. The package according to any one of claim 1 to 2, wherein the fluoro-based red phosphors (150) have a center emission wavelength within a range from 620 nm to 640 nm.

4. The package according to any one of claim 1 to 3, wherein the light in the first wavelength range has a center wavelength within a range from 440 nm to 460 nm.

5. The package according to any one of claim 1 to 4, wherein the light in the second wavelength range has a center wavelength within a range from 520 nm to 535 nm.

6. The package according to any one of claim 1 to 5, wherein the molding part (160) includes a resin base, and the fluoro-based red phosphors (150) spaced apart from one another by a predetermined distance within the resin base, such that the fluoro-based red phosphors (150) are distributed in the resin base.

7. The package according to claim 6 when combined with claim 2, wherein the fluoro-based red phosphors (150) are excited by both of the first light emitted from the first light-emitting device (110a) and the second light emitted from the second light-emitting device (110b).

8. A light-emitting device package comprising:

a first light-emitting device (110a) disposed on a lead frame (142, 144) and configured to emit light in a first wavelength range and a second light-emitting device (110b) configured to emit light in a second wavelength range, which is different from the first wavelength range; and

a molding part (160) disposed to surround the first light-emitting device (110a) and the second light-emitting device (110b),

wherein the molding part (160) includes red phosphors (150), which are excited by the light emitted from at least one of the first light-emitting device (110a) and the second light-emitting device (110b), and

wherein the molding part (160) has a dome shape, and varies an emission angle of light from the first light-emitting device (110a) and the second light-emitting device (110b),

**characterized in that**

the red phosphors are fluoro-based red phosphors (150), and red light emitted from the fluoro-based red phosphors (150) has color coordinates, located within a rectangle defined by X and Y coordinates, of (0.600, 0.260), (0.690, 0.260), (0.600, 0.310) and (0.690, 0.310) on the basis of CIEI 1931 color coordinate system, and wherein the fluoro-based red phosphors (150) are included in the molding part in an amount within a range from 5 wt% to 25 wt%.

9. The package according to claim 8, wherein the fluoro-based red phosphors (150) have a full width at half maximum within a range from 5 nm to 10 nm.

10. The package according to any one of claim 8 to 9, wherein the light in the first wavelength range has a center wavelength within a range from 440 nm to 460 nm.

**11.** The package according to any one of claim 8 to 10, wherein the light in the second wavelength range has a center wavelength within a range from 520 nm to 535 nm.

**12.** The package according to claim any one of 8 to 11, wherein the molding part (160) includes a resin base, and the fluoro-based red phosphors (150) spaced apart from one another by a predetermined distance within the resin base, such that the fluoro-based red phosphors (150) are distributed in the resin base.

**13.** The package according to claim 12, wherein the fluoro-based red phosphors (150) are indicated by the chemical formula $K_2MF_6:Mn^{4+}$ (here, M is at least one of Si, Ge, and Ti), and the fluoro-based red phosphors (150) are excited by both of the first light emitted from the first light-emitting device (110a) and the second light emitted from the second light-emitting device (110b).

**14.** A lighting apparatus comprising:
a light-emitting device package (200a) according to claim 1.

**15.** The lighting apparatus according to claim 14, wherein the light-emitting device package (200a) emits white light in which blue light, green light and red light are mixed.

**Patentansprüche**

**1.** Leuchtbauelementgehäuse, das aufweist:

ein erstes Leuchtbauelement (110a), das auf einem Systemträger (142, 144) angeordnet und so konfiguriert ist, dass es Licht in einem ersten Wellenlängenbereich abstrahlt, und ein zweites Leuchtbauelement (110b), das so konfiguriert ist, dass es Licht in einem zweiten Wellenlängenbereich abstrahlt, der sich vom ersten Wellenlängenbereich unterscheidet; und
ein Formteil (160), das so angeordnet ist, dass es das erste Leuchtbauelement (110a) und das zweite Leuchtbauelement (110b) umgibt,
wobei das Formteil (160) Rotleuchtstoffe (150) aufweist, die durch das Licht angeregt werden, das vom ersten Leuchtbauelement (110a) und/oder zweiten Leuchtbauelement (110b) abgestrahlt wird, und
wobei das Formteil (160) eine Kuppelform hat und einen Abstrahlwinkel von Licht vom ersten Leuchtbauelement (110a) und zweiten Leuchtbauelement (110b) variiert,
**dadurch gekennzeichnet, dass** die Rotleuchtstoffe fluorbasierte Rotleuchtstoffe (150) sind,
wobei die fluorbasierten Rotleuchtstoffe (150) eine Halbwertsbreite in einem Bereich von 5 nm bis 10 nm haben und
wobei die fluorbasierten Rotleuchtstoffe (150) in einer Menge in einem Bereich von 5 Gew.-% bis 25 Gew.-% zum Formteil gehören.

**2.** Gehäuse nach Anspruch 1, wobei die fluorbasierten Rotleuchtstoffe (150) durch die chemische Formel $K_2MF_6:Mn^{4+}$ angegeben sind (wobei es sich bei M um Si, Ge und/oder Ti handelt).

**3.** Gehäuse nach Anspruch 1 oder 2, wobei die fluorbasierten Rotleuchtstoffe (150) eine Mittenemissionswellenlänge in einem Bereich von 620 nm bis 640 nm haben.

**4.** Gehäuse nach einem der Ansprüche 1 bis 3, wobei das Licht im ersten Wellenlängenbereich eine Mittenwellenlänge in einem Bereich von 440 nm bis 460 nm hat.

**5.** Gehäuse nach einem der Ansprüche 1 bis 4, wobei das Licht im zweiten Wellenlängenbereich eine Mittenwellenlänge in einem Bereich von 520 nm bis 535 nm hat.

**6.** Gehäuse nach einem der Ansprüche 1 bis 5, wobei das Formteil (160) eine Harzbasis aufweist und die fluorbasierten Rotleuchtstoffe (150) einen vorbestimmten Abstand voneinander in der Harzbasis so haben, dass die fluorbasierten Rotleuchtstoffe (150) in der Harzbasis verteilt sind.

**7.** Gehäuse nach Anspruch 6 in Kombination mit Anspruch 2, wobei die fluorbasierten Rotleuchtstoffe (150) sowohl durch das vom ersten Leuchtbauelement (110a) abgestrahlte erste Licht als auch durch das vom zweiten Leuchtbauelement (110b) abgestrahlte zweite Licht angeregt werden.

8. Leuchtbauelementgehäuse, das aufweist:

ein erstes Leuchtbauelement (110a), das auf einem Systemträger (142, 144) angeordnet und so konfiguriert ist, dass es Licht in einem ersten Wellenlängenbereich abstrahlt, und ein zweites Leuchtbauelement (110b), das so konfiguriert ist, dass es Licht in einem zweiten Wellenlängenbereich abstrahlt, der sich vom ersten Wellenlängenbereich unterscheidet; und

ein Formteil (160), das so angeordnet ist, dass es das erste Leuchtbauelement (110a) und das zweite Leuchtbauelement (110b) umgibt,

wobei das Formteil (160) Rotleuchtstoffe (150) aufweist, die durch das Licht angeregt werden, das vom ersten Leuchtbauelement (110a) und/oder zweiten Leuchtbauelement (110b) abgestrahlt wird, und

wobei das Formteil (160) eine Kuppelform hat und einen Abstrahlwinkel von Licht vom ersten Leuchtbauelement (110a) und zweiten Leuchtbauelement (110b) variiert,

**dadurch gekennzeichnet, dass** die Rotleuchtstoffe fluorbasierte Rotleuchtstoffe (150) sind und von den fluorbasierten Rotleuchtstoffen (150) abgestrahltes Rotlicht Farbkoordinaten hat, die in einem Rechteck liegen, das durch X- und Y-Koordinaten (0,600, 0,260), (0,690, 0,260), (0,600, 0,310) und (0,690, 0,310) auf der Grundlage des Farbkoordinatensystems nach CIEI 1931 festgelegt sind, und

wobei die fluorbasierten Rotleuchtstoffe (150) in einer Menge in einem Bereich von 5 Gew.-% bis 25 Gew.-% zum Formteil gehören.

9. Gehäuse nach Anspruch 8, wobei die fluorbasierten Rotleuchtstoffe (150) eine Halbwertsbreite in einem Bereich von 5 nm bis 10 nm haben.

10. Gehäuse nach Anspruch 8 oder 9, wobei das Licht im ersten Wellenlängenbereich eine Mittenwellenlänge in einem Bereich von 440 nm bis 460 nm hat.

11. Gehäuse nach einem der Ansprüche 8 bis 10, wobei das Licht im zweiten Wellenlängenbereich eine Mittenwellenlänge in einem Bereich von 520 nm bis 535 nm hat.

12. Gehäuse nach einem der Ansprüche 8 bis 11, wobei das Formteil (160) eine Harzbasis aufweist und die fluorbasierten Rotleuchtstoffe (150) einen vorbestimmten Abstand voneinander in der Harzbasis so haben, dass die fluorbasierten Rotleuchtstoffe (150) in der Harzbasis verteilt sind.

13. Gehäuse nach Anspruch 12, wobei die fluorbasierten Rotleuchtstoffe (150) durch die chemische Formel $K_2MF_6$:$Mn^{4+}$ angegeben sind (wobei es sich bei M um Si, Ge und/oder Ti handelt) und die fluorbasierten Rotleuchtstoffe (150) sowohl durch das vom ersten Leuchtbauelement (110a) abgestrahlte erste Licht als auch durch das vom zweiten Leuchtbauelement (110b) abgestrahlte zweite Licht angeregt werden.

14. Beleuchtungsvorrichtung, die aufweist:
ein Leuchtbauelementgehäuse (200a) nach Anspruch 1.

15. Beleuchtungsvorrichtung nach Anspruch 14, wobei das Leuchtbauelementgehäuse (200a) Weißlicht abstrahlt, in dem Blaulicht, Grünlicht und Rotlicht gemischt sind.


**Revendications**

1. Composant de dispositif électroluminescent, comprenant :

un premier dispositif électroluminescent (110a) disposé sur une grille de connexion (142, 144) et configuré pour émettre de la lumière dans une première plage de longueurs d'onde et un second dispositif électroluminescent (110b) configuré pour émettre de la lumière dans une seconde plage de longueurs d'onde, qui est différente de la première plage de longueurs d'onde ; et

une partie de moulage (160) disposée pour entourer le premier dispositif électroluminescent (110a) et le second dispositif électroluminescent (110b),

dans lequel la partie de moulage (160) inclut des luminophores rouges (150), qui sont excités par la lumière émise à partir d'au moins un du premier dispositif électroluminescent (110a) et du second dispositif électroluminescent (110b), et

dans lequel la partie de moulage (160) a une forme de dôme, et varie un angle d'émission de lumière provenant du premier dispositif électroluminescent (110a) et du second dispositif électroluminescent (110b), **caractérisé en ce que** les luminophores rouges sont des luminophores rouges à base de fluor (150),

dans lequel les luminophores rouges à base de fluor (150) ont une largeur à mi-hauteur au sein d'une plage de 5 nm à 10 nm, et

dans lequel les luminophores rouges à base de fluor (150) sont inclus dans la partie de moulage en une quantité au sein d'une plage de 5 % en poids à 25 % en poids.

2. Composant selon la revendication 1, dans lequel les luminophores rouges à base de fluor (150) sont indiqués par la formule chimique $K_2MF_6$:$Mn^{4+}$ (ici, M est au moins un de Si, de Ge, et de Ti).

3. Composant selon l'une quelconque des revendications 1 à 2, dans lequel les luminophores rouges à base de fluor (150) ont une longueur d'onde d'émission centrale au sein d'une plage de 620 nm à 640 nm.

4. Composant selon l'une quelconque des revendications 1 à 3, dans lequel la lumière dans la première plage de longueurs d'onde a une longueur d'onde centrale au sein d'une plage de 440 nm à 460 nm.

5. Composant selon l'une quelconque des revendications 1 à 4, dans lequel la lumière dans la seconde plage de longueurs d'onde a une longueur d'onde centrale au sein d'une plage de 520 nm à 535 nm.

6. Composant selon l'une quelconque des revendications 1 à 5, dans lequel la partie de moulage (160) inclut une base de résine, et les luminophores rouges à base de fluor (150) espacés les uns des autres d'une distance prédéterminée à l'intérieur de la base de résine, de sorte que les luminophores rouges à base de fluor (150) soient distribués dans la base de résine.

7. Composant selon la revendication 6 lorsqu'elle est associée à la revendication 2, dans lequel les luminophores rouges à base de fluor (150) sont excités à la fois par la première lumière émise à partir du premier dispositif électroluminescent (110a) et la seconde lumière émise à partir du second dispositif électroluminescent (110b).

8. Composant de dispositif électroluminescent comprenant :

un premier dispositif électroluminescent (110a) disposé sur une grille de connexion (142, 144) et configuré pour émettre de la lumière dans une première plage de longueurs d'onde et un second dispositif électroluminescent (110b) configuré pour émettre de la lumière dans une seconde plage de longueurs d'onde, qui est différente de la première plage de longueurs d'onde ; et

une partie de moulage (160) disposée pour entourer le premier dispositif électroluminescent (110a) et le second dispositif électroluminescent (110b),

dans lequel la partie de moulage (160) inclut des luminophores rouges (150), qui sont excités par la lumière émise à partir d'au moins un du premier dispositif électroluminescent (110a) et du second dispositif électroluminescent (110b), et

dans lequel la partie de moulage (160) a une forme de dôme, et varie un angle d'émission de lumière provenant du premier dispositif électroluminescent (110a) et du second dispositif électroluminescent (110b),

**caractérisé en ce que**

les luminophores rouges sont des luminophores rouges à base de fluor (150), et de la lumière rouge émise à partir des luminophores rouges à base de fluor (150) a des coordonnées de couleur, situées à l'intérieur d'un rectangle défini par des coordonnées X et Y, de (0,600, 0,260), de (0,690, 0,260), de (0,600, 0,310) et de (0,690, 0,310) sur la base du système de coordonnées de couleur CIEl 1931, et

dans lequel les luminophores rouges à base de fluor (150) sont inclus dans la partie de moulage en une quantité au sein d'une plage de 5 % en poids à 25 % en poids.

9. Composant selon la revendication 8, dans lequel les luminophores rouges à base de fluor (150) ont une largeur à mi-hauteur au sein d'une plage de 5 nm à 10 nm.

10. Composant selon l'une quelconque des revendications 8 à 9, dans lequel la lumière dans la première plage de longueurs d'onde a une longueur d'onde centrale au sein d'une plage de 440 nm à 460 nm.

11. Composant selon l'une quelconque des revendications 8 à 10, dans lequel la lumière dans la seconde plage de longueurs d'onde a une longueur d'onde centrale au sein d'une plage de 520 nm à 535 nm.

**12.** Composant selon l'une quelconque des revendications 8 à 11, dans lequel la partie de moulage (160) inclut une base de résine, et les luminophores rouges à base de fluor (150) espacés les uns des autres d'une distance prédéterminée à l'intérieur de la base de résine, de sorte que les luminophores rouges à base de fluor (150) soient distribués dans la base de résine.

**13.** Composant selon la revendication 12, dans lequel les luminophores rouges à base de fluor (150) sont indiqués par la formule chimique $K_2MF_6$:$Mn^{4+}$ (ici, M est au moins un de Si, de Ge, et de Ti), et les luminophores rouges à base de fluor (150) sont excités à la fois par la première lumière émise à partir du premier dispositif électroluminescent (110a) et la seconde lumière émise à partir du second dispositif électroluminescent (110b).

**14.** Appareil d'éclairage comprenant :
un composant de dispositif électroluminescent (200a) selon la revendication 1.

**15.** Appareil d'éclairage selon la revendication 14, dans lequel le composant de dispositif électroluminescent (200a) émet de la lumière blanche dans laquelle de la lumière bleue, de la lumière verte et de la lumière rouge sont mélangées.

200a

FIG.1

110

FIG.2

200b

135          150          160

110b

146
110a

144          144

142   130   142

FIG.3

300

200
210

FIG.5

FIG.4a

EP 3 057 131 B1

FIG.4b.

Power

Wave Length (nm)

EXAMPLE 1
EXAMPLE 2
EXAMPLE 3
EXAMPLE 4

380  430  480  530  580  630  680  730  780

3.00E-04
2.50E-04
2.00E-04
1.50E-04
1.00E-04
5.00E-05
0.00E+00

FIG.6

Cx

Cy

R
G
B

NTSC
COMPARATIVE EXAMPLE 1
COMPARATIVE EXAMPLE 2

FIG.7

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014068440 A1
- US 20150008463 A1
- US 20090243504 A1
- US 20080048193 A1
- WO 2014104147 A